# EUROPEAN PATENT APPLICATION

(11) **EP 0 776 035 A1**
(43) Date of publication of application: **28.05.1997**
(21) Application number: 96916323.7
(22) Date of filing: 06.06.1996
(51) Int. Cl.: H01L 21/68, B65G 49/07, B25J 19/00

(54) **SUBSTRATE CARRYING DEVICE**

(30) Priority: 08.06.1995 JP 142128/95
(71) Applicant: KOKUSAI ELECTRIC CO., LTD., Tokyo 164 (JP)
(72) Inventor: TAKEBAYASHI, Yuji, Kokusai Electric Co., Ltd., Nakano-ku, Tokyo 164 (JP); AKAO, Tokunobu, Kokusai Electric Co., Ltd., Nakano-ku, Tokyo 164 (JP); KONNO, Yoshikazu, Kokusai Electric Co., Ltd., Nakano-ku, Tokyo 164 (JP)
(74) Representative: Jackson, Peter Arthur
(86) International application number: PCT/JP96/01531
(87) International publication number: WO 96/42108

(57) **Abstract**

It is an object of the present invention to provide a substrate carrying apparatus in which locating of substrate can be made without additional load being applied on a carrying arm.

A substrate carrying apparatus comprises a frame 11, a rotary shaft 12, supported by the frame 11 so as to be rotatable and movable vertically relative to the frame 11, a carrying arm 14 pivoted to the rotary shaft 12, a substrate receiver 16 attached to an end of the carrying arm and receiving a substrate 18. A guide base 20 is mounted on the rotary shaft 12 on the lower side of the substrate receiver 16 in such a manner that the guide base 20 is approximately parallel to the substrate receiver 16, and a substrate alignment mechanism 21 is attached to rotary shaft 12 via guide base 20. Substrate alignment mechanism 21 includes a pair of location correcting members 24,24 which are coupled to air cylinders 22, 22. Location correcting members 24,24 are displaced by air cylinders 22, 22 to correct location of substrate 18.

## Description

### Field of the Invention

The present invention relates to a substrate carrying apparatus for carrying processed substrates, particularly to a substrate carrying apparatus in which locating of substrates is possible.

### Description of the Background Information

As for the above-mentioned substrate carrying apparatus, heretofore, there is, for example, a substrate carrying apparatus which is described in Japanese Patent Laying Open (Kokai) No. 65149 of Heisei 4 (1992). The substrate carrying apparatus disclosed in the Japanese Patent Laying Open comprises a carrying arm including a plurality of pivot joints, a substrate receiver provided on a head of carrying arm, a substrate engaging portion provided at a head of substrate receiver, and a locating member which is provided above the substrate receiver and in the direction of the width of substrate receiver, supported to the substrate receiver by a connecting portion, in such a manner that the locating member can move forward or backward by the revolution of the substrate receiver. As for X-axis of substrate, the locating member advances in such a manner that the substrate is inserted between the locating member and the substrate engaging portion, by which the locating of substrate is made, and as for Y-axis of substrate, the substrate is inserted between pushing plates which are provided at both ends of the locating member, by which the location of substrate is made.

By the way, in recent years, there is a tendency that processed substrates are being large-sized. This is due to the productivity increase in the production of semiconductor or to the increased demand for large-sized liquid crystal display substrate in LCD liquid display. Together with this, a substrate itself becomes heavier, load applied on a carrying arm becomes higher.

However, in the above-mentioned example, since the locating member is supported by the substrate receiver by the connecting portion, weight of substrate receiver is applied on the carrying arm, and thereby the carrying arm is bent, and so there is a fear that carrying of substrate is hindered. Further, the load of carrying arm applied on driving means for driving the carrying arm is increased.

Further, in case of locating substrates, it is desirable to reduce a contacting area with substrate is as little as possible in order to prevent contamination of substrate. However, in the above-mentioned conventional example, members for locating substrate relative to X-axis, and members for locating substrate relative to Y-axis, in addition to a substrate-receiving part, are brought into contact with substrate, respectively, therefore total contacting area becomes larger.

Further, since the shape of substrate receiver itself is conformed to the shape of substrate, the larger a substrate becomes, the larger a substrate receiver becomes. Therefore, bending of substrate receiver is caused by empty weight, by which the head of substrate is bent, and so there is a fear that carrying of substrate is hindered.

It is an object of the present invention to provide a substrate carrying apparatus in which locating of substrate can be made without additional load being applied on a carrying arm.

It is a further object of the present invention to provide a substrate carrying apparatus in which area being in contact with substrate is made as smaller as possible, so that locating of substrate can be made while contamination of substrate being reduced to a minimum.

It is a still further object of the present invention to provide a substrate carrying apparatus in which load applied on a carrying arm can be reduced by making a substrate receiver light-weight.

### DISCLOSURE OF INVENTION

To achieve the above-mentioned object, a substrate carrying apparatus according to the present invention comprises a frame, a rotary shaft mounted on frame so as to be rotatable and movable vertically relative to the frame, a carrying arm pivoted to the rotary shaft, a substrate receiver attached to an end of the carrying arm to receive a substrate thereon. The substrate carrying apparatus further comprises substrate alignment mechanism means for locating the substrate on the substrate receiver; said substrate alignment mechanism means being attached to the rotary shaft via a guide base.

Locating of substrate is made by the substrate alignment mechanisms attached to the rotary shaft via a guide base. Load of the substrate alignment mechanisms is applied on the guide base, but not applied on the carrying arm.

Since the guide base is rotated together with the rotary shaft, the substrate alignment mechanisms can hold substrate during rotation of the rotary shaft. Therefore, a shift of substrate from the proper location is not caused even if the rotary shaft rotates at high speed. Accordingly, the substrate carrying can be made accurately at high speed.

Further, a substrate carrying apparatus according to the present invention, the substrate alignment mechanism may include at least a pair of location correcting members which are coupled to driving means and disposed so as to oppose with each other with placing the substrate between the pair of location correcting members, and each locating correction member is displaced by the driving means so that it can be brought into contact with the substrate. Alternatively, the substrate alignment mechanism may include at least a pair of location correcting members, one of which is fixed to the guide base and the other of which is coupled to driving means, and said location correcting members are disposed so as to oppose with each other with placing the substrate between them, and the other of the location correcting members is displaced by the driving means so that each locating correction member can be brought into contact with the substrate.

Still further, the substrate carrying apparatus according to the present invention comprises a frame; a rotary shaft supported by the frame so as to be rotatable and movable vertically relative to the frame; a carrying arm pivoted to the rotary shaft; a substrate receiver attached to an end of the carrying arm, wherein a substrate is put on the substrate receiver. The substrate carrying apparatus further comprises a guide base which is fixed to the rotary shaft in such a manner that the guide base is approximately parallel to the substrate receiver below the substrate receiver; driving means supported by the guide base; location correcting members extending above the substrate receiver and coupled to the driving means, wherein the location correcting members are displaced by the driving means so that the substrate is held in place.

Since loads of the driving means and the location correcting members are applied on the rotary shaft via guide base, the carrying arms can be freed from the loads.

Further, the location correcting members may be disposed on a diagonal line of the rectangular substrate.

Still further, each location correcting members are preferably constructed so that they can be brought into contact with adjacent sides of the substrate at a corresponding corner of the rectangular substrate.

Since locating of substrate relative to both X-axis and Y-axis can be made by that the location correcting members insert diagonally opposed corners of the substrate, construction for locating of substrate can be simplified.

Preferably, each location correcting members has a contact portion which has a circular profile or an ellipse profile from a plan view. Contacting area of the substrate carrying apparatus with substrate can be reduced to the most.

Further, the substrate carrying apparatus according to the present invention, the substrate receiver can have a base portion which is attached to the carrying arm, a plurality of pawl portions which diverges from the base portion and extends toward the head of individual pawl portion, wherein width of individual pawl portion tapers down toward the head.

By providing a plurality of pawl portions having width of individual pawl portion which tapers down toward the head of individual portion, the strength of frame area of the substrate receiver can be preserved, while moment of rotation applied on pawl portion due to empty weight of pawl portion is made smaller in such an extent that bending of the substrate receiver can be prevented.

Further the thickness of individual pawl portion may be thinner toward the head. Weight of the head of pawl portion can be reduced by adjusting the thickness of pawl portion.

Still further, the substrate receiver may have a bridge portion connecting the pawl portions with each other at the appropriate positions of the pawl portions. Reinforcement can be made by connecting individual pawl portions with each other through the bridge portion, simultaneously load applied on individual pawl portion can be equalized in such an extent that the substrate receiver can be prevented from inclining.

### BRIEF DESCRIPTION OF THE DRAWING

Fig. 1 is a sectional side elevation of an embodiment of a substrate carrying apparatus according to the present invention;
Fig. 2 is a plan view of the apparatus shown in Fig. 1;
Fig. 3 is a sectional view taken on line 3-3 of Fig. 1;
Fig. 4 is a plan view of a substrate receiver used in Fig. 1;
Figs. 5 (a), (b), (c) are side views of substrate receivers, respectively.
Fig. 6 is a layout drawing of an example of semiconductor manufacturing apparatus in which the substrate carrying apparatus of the present invention is used;
Fig. 7 is a sectional view of the processing room R1 of Fig. 6 in which a susceptor is ascending;
Fig. 8 is a sectional view of the processing room R1 of Fig. 6 in which a susceptor is descending;
Fig. 9 is a time chart of operations of the semiconductor manufacturing apparatus of Fig. 6;
Fig. 10 is a plan view corresponding to Fig. 2 of another embodiment of a substrate carrying apparatus according to the present invention;
Fig. 11 is a plan view corresponding to Fig. 2 of yet another embodiment of a substrate carrying apparatus according to the present invention;
Fig. 12 is a plan view corresponding to Fig. 2 of still another embodiment of a substrate carrying apparatus according to the present invention;
Fig. 13 is a plan view of an important portion of another version of a substrate carrying apparatus according to the present invention.

### PREFERRED EMBODIMENT TO EMBODY INVENTION

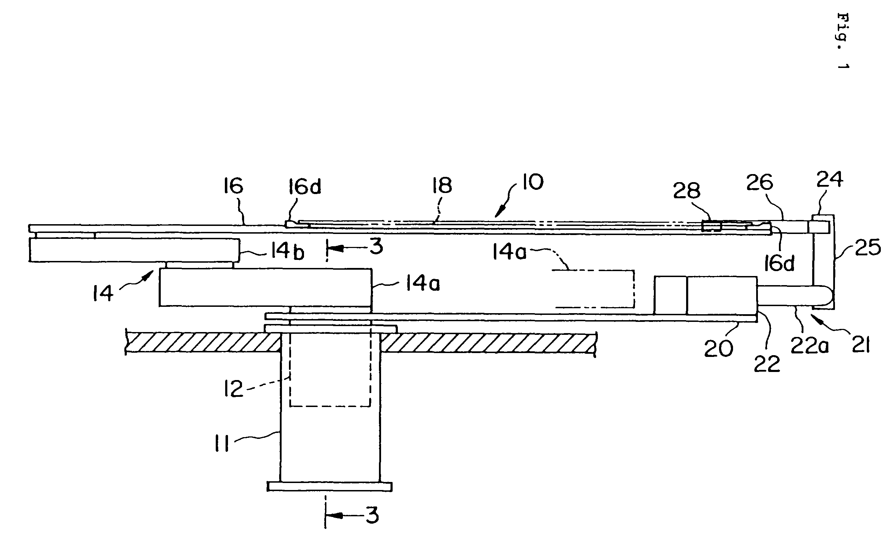

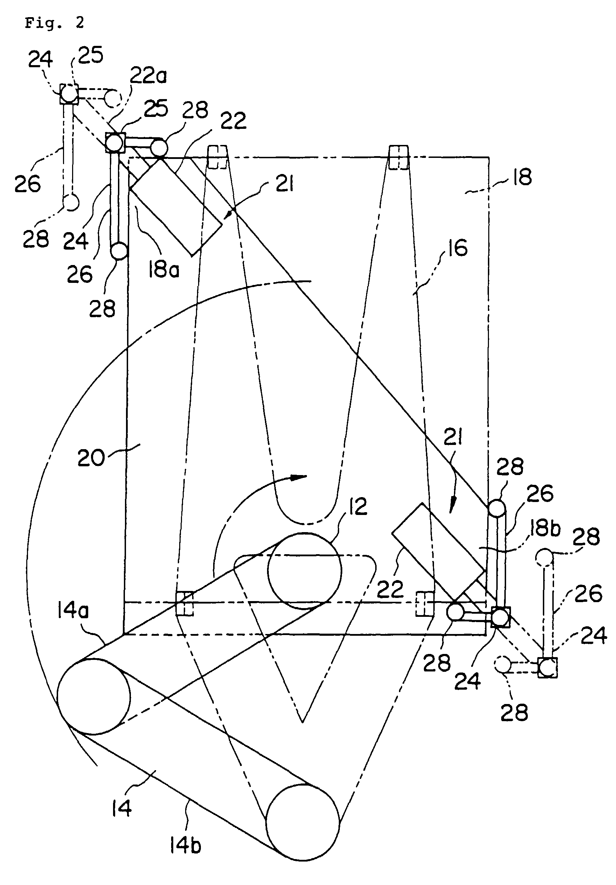

Fig. 1 is a sectional side elevation of an embodiment of a substrate carrying apparatus according to the present invention and Fig. 2 is a plan view of the apparatus shown in Fig. 1.

Referring to Fig. 1, a substrate carrying apparatus 10 comprises a frame 11. A rotary shaft 12 is supported by frame 11 so as to be rotatable and movable vertically relative to frame 11. A carrying arm 14 is pivoted rotatably to a top end of rotary shaft 12. Carrying arm 14 is comprised of a plurality of articulated arms 14a, 14b. One of the articulated arms 14a, 14b is bent or contracted, extended relative to the other thereof so that the whole of carrying arm 14 can be extended or contracted. A substrate receiver 16 is attached to an end of carrying arm 14. Substrate 18 is placed on substrate receiver 16, and carried.

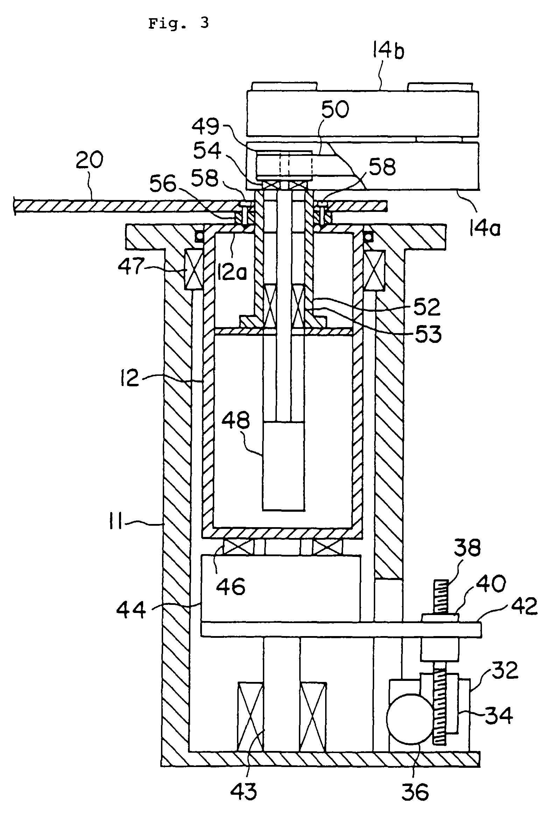

Fig. 3 is a detailed sectional view showing a portion including frame 11, rotary shaft 12 and carrying arm 14. A motor 32 for vertical travel of rotary shaft and carrying arm is mounted on the bottom of frame 11 so that a screw 38 can be rotated by the rotation of motor 32 transmitted through gears 34, and 36 to the screw 38 and so the rotation of screw 38 makes a bush 40 threadably engaged with the screw 38 move vertically. Table 42 secured to bush 40 is moved vertically relative to frame 11, together with bush 40 as table 42 is guided by a guide shaft 43 secured to frame 11. A motor 44 for rotation of rotary shaft is mounted on table 42. Rotary shaft 12 is mounted on motor 44 for rotation of rotary shaft through a guide 46. The driving shaft of motor 44 is connected with rotary shaft 12 so that rotary shaft 12 can be rotated relative to frame 11 by the rotation of motor 44 for rotating rotary shaft. In the drawing, numeral 47 designates a guide for supporting rotary shaft 12 against frame 11 in such a manner that the rotary shaft 12 is rotatable and movable vertically relative to frame 11. By the above-mentioned construction, rotary shaft 12 is mounted to frame 11 to be rotatable and movable vertically relative to frame 11.

Rotary shaft 12 incorporates a motor 48 for rotation of arm thereinside. The driving shaft of motor 48 for rotation of arm is connected with a pulley 49 which is mounted inside articulated arm 14a of carrying arm 14, through a tubular body 52 with a lower end secured to rotary shaft 12 and a top end which supports carrying arm 14. In the drawing, numerals 53, 54 designate guides which supports rotatably the driving shaft of motor 48. A timing belt 50 is wound on pulley 49. Further, the timing belt 50 is wound on another pulley which is mounted at the other end of articulated arm 14a in such a manner that articulated arm 14b can be rotated. Further, another timing belt is provided in articulated arm 14b so that substrate receiver 16 can be rotated. Accordingly, the drive of motor 48 for rotation of arm makes articulated arm 14a, articulated arm 14b and substrate receiver 16 rotate so that the whole of carrying arm 14 is extended or contracted.

A guide base 20 is secured to rotary shaft 12 in a lower position than carrying arm 14. Namely spacer 56 is interposed between rotary shaft 12 and guide base 20. Guide base 20 is secured to the rotary shaft 12 with a plurality of screws 58, 58. Screws 58, 58 do not penetrate lid plate portion 12a of the rotary shaft 12 to maintain sealing of the room. Guide base 20 is positioned below substrate receiver 16 in such a manner that guide base 20 is approximately parallel to substrate receiver 16.

A substrate alignment mechanism 21 is attached to the rotary shaft 12 via guide base 20 in order to align the substrate 18 to be placed on the substrate receiver 16. Guide base 20 has the shape of rectangle a corner of which is cut off, as shown in Fig. 2, in such a manner that the guide base 20 connects the substrate alignment mechanism 21 with rotary shaft 12. Preferably, in order that guide base 20 is prevented from not being bent by the weight of air cylinders 22, 22 and substrate alignment mechanism 24, the thickness of guide base 20 may be appropriately selected, or the area thereof may be widened, or other counterplan may be considered. Further guide base 20 may be constructed by not only one part but also a plurality of parts.

Substrate alignment mechanism 21 includes a pair of location correcting members 24 which are coupled to piston rods 22a, 22a of a pair of air cylinders 22, 22 as driving means respectively. Two air cylinders 22, 22 are mounted on guide base 20.

However driving means 22, 22 are not limited to mounted on the upper surface of guide base 20 as shown, however driving means 22, 22 can be alternatively secured to the lower surface of the guide base 20 by any screws as fixing means. Further motors, linear solenoids or others can be substituted for air cylinders 22 as driving means.

Two location correcting members 24 are disposed on a diagonal line of rectangular substrate 18 to be placed on substrate receiver 16 with placing substrate 18 between them, corresponding to diagonally opposed corners 18a, 18b of the rectangular substrate 18.

Individual locate alignment mechanism 24 is comprised of an arm 25 extending perpendicularly relative to piston rod 22a, a holder 26 having an L-shaped profile from a plan view which is secured to a top end of the arm 25 and contact portions 28 which are secured to both ends of the holder 26 and can be brought into contact with a substrate. L-shaped holder 26 has two sides which are parallel to the adjacent sides near corners 18a, 18b of substrate 18 which has been located, respectively.

Material of contact portion 28 can be selected from material that has the lower influence of contamination on substrate, such as Teflon, polyimide or the like. Further, contact portion 28 has a circular profile from a plan view and a column shape in 3 dimensional space so that it comes in line touch with substrate 18. Alternatively, contact portion 28 has a sphere shape to come in spot touch with substrate 18, thereby contacting area with substrate 18 can be reduced. However, the shape of contact portion 28 is not restricted to a circular profile from a plan view, but it may be noncircular, for example, an ellipse profile from a plan view as shown by contact portion 28-1 in Fig. 13. Although a shape of contact portion 28 may be a circular profile or an ellipse profile from a plan view in order to prevent abrasion because it can be brought into contact with substrate 18 at curved surface of contact portion 28, a shape of contact portion 28 can be polygon having corners more than three. In either case, area of contact should be controlled to be smaller. Further although in an example shown in Fig. 2, one contact portion 28 is brought into contact with individual side of substrate 18, contact portions more than two can be provided to touch against individual side of substrate 18.

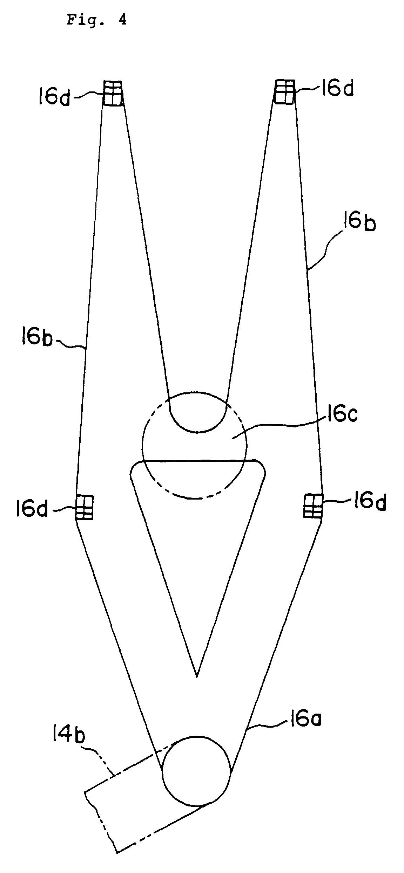

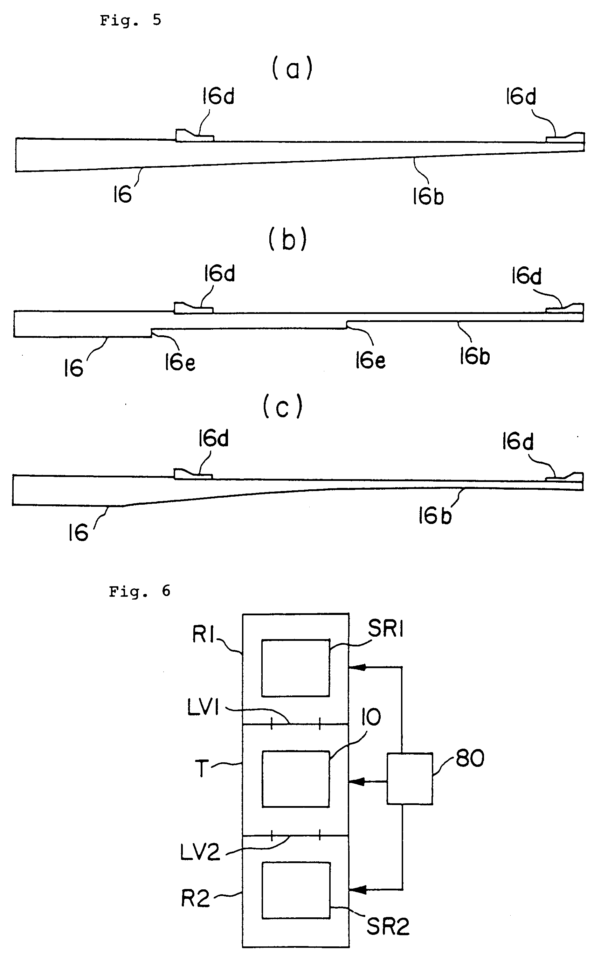

As shown in Fig. 4, substrate receiver 16 has a base portion 16a which is attached to carrying arm 14, two pawl portions 16b, 16b which extend right and left from the base portion 16a, and a bridge portion 16c which connects two pawl portions 16b, 16b with each other in a substantial intermediate portion of each pawl portion 16b in a longitudinal direction thereof. Holding pins 16d, 16d for holding substrate 18 are provided on individual pawl portion 16b in such a manner that the holding pins 16d, 16d are brought into contact with the peripheral portion of substrate 18. Width of the head of individual pawl portion 16b beyond bridge portion 16c tapers down toward the head. Further, as shown in Fig. 5 (a), the upper surface of pawl portion can be kept to be approximately horizontal, while the lower surface of pawl portion 16b is gradually inclined upward toward the head so that the thickness of individual pawl portion 16b is thinner toward the head thereof. By the above-mentioned construction, moment of rotation which is applied on pawl portion 16b due to dead load of pawl portion 16b can be made small, and thereby bending of pawl portion 16b can be lessened to the utmost while the strength of base portion 16a can be maintained. As for the thickness of pawl portion 16b, in addition to an example shown in Fig. 5 (a), there are another example that stairs 16e, 16e more than two are formed on the lower surface of pawl portion 16b as shown in Fig. 5(a) so that the thickness of pawl portion 16b is reduced in stages, and further another example that a curved surface is formed on the lower surface of pawl portion 16b, as shown in Fig. 5 (c).

Since the reinforcement is made by connecting a plurality of pawl portion 16b, 16b with each other through bridge portion 16c, when large load is applied on one pawl portion 16b, the load is transmitted to the other pawl portion 16b so that the ill-balanced stress is relaxed so that substrate 18 is always maintained at approximately horizontal condition without being inclined. However depending on the shape or size of the base portion 16a, the bridge portion 16c can be eliminated. Further, pawl portions 16b, 16b are formed symmetrically. Accordingly, since the distribution of load of substrate receiver 16 itself is symmetric, even if pawl portions 16b, 16b are slightly bent, the extent of bending of one pawl portion 16b is made approximately equal to that of the other pawl portion 16b so that substrate 18 is prevented from being inclined right or left.

In the substrate carrying apparatus which is constructed as described above, when substrate alignment mechanism 21 corrects location of substrate 18, piston rods 22a of air cylinders 22, 22 are contracted so that both arms 25 move toward substrate 18. Position of substrate alignment mechanism 21 is previously determined so that there is a clearance, such as 0.1 to 0.5mm between contact portion 28 and substrate 18 when substrate 18 is properly located and piston rods 22a of air cylinders are contracted as possible as they can. Namely this clearance becomes a tolerance of location of substrate 18. If location of substrate 18 is out of the tolerance, contact portion 28 contacts substrate 18 and corrects its position so as to be in the tolerance. Since contact portions 28 are provided to correspond to opposite corners 18a, 18b of substrate 18, substrate 18 is located properly in both X-axis and Y-axis. When substrate alignment mechanism 21 acts on substrate 18, substrate 18 can be held in place even if rotary shaft 12 is rotated at high speed.

When piston rods 22a of air cylinders 22, 22 is extended, contact portions 28 leave corners 18a, 18b, and substrate 18 is released from contact portions 28( see "a condition shown in imaginary line in Fig. 2").

As described, because the clearance which defines tolerance of location of substrate is provided, substrate 18 is prevented from being too biased to one side even if driving speeds of air cylinder 22, 22 differs from each other, and contacting area of contact portions 28 with substrate 18 can be reduced to the most.

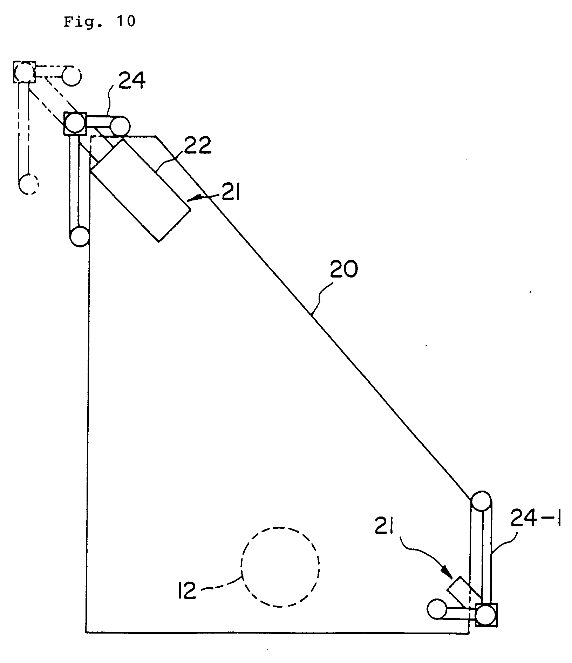

Fig. 10 is a plan view corresponding to Fig. 2 of another embodiment according to the present invention.

Substrate alignment mechanism 21 attached to rotary shaft 12 via guide base 20 according to the present example includes a pair of location correcting members 24, 24-1, one location correcting member 24-1 being fixed to guide base 20 while the other location correcting member 24 being coupled to air cylinder 22. This pair of location correcting members 24, 24-1 are disposed on a diagonal line of rectangular substrate 18 to be placed on substrate receiver 16 with placing substrate 18 between them, corresponding to diagonally opposed corners 18a, 18b of the rectangular substrate 18.

In this embodiment, the other location correcting member 24 is the same as the location correcting member 24 of Fig. 2 in that it is movable by driving of air cylinder 22, while one location correcting member 24 differs from the location correcting member 24 of Fig. 2 in that it is not movable. Both location correcting members 24, 24-1, however, operates in a similar manner to that of Fig. 2 by that they hold opposite corners 18a , 18b of substrate 18.

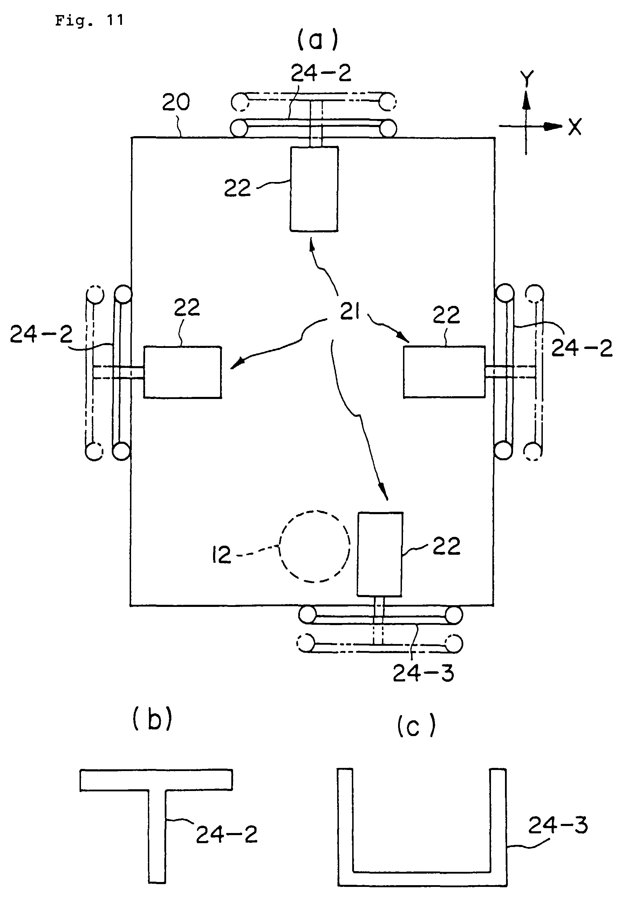

Fig. 11 is a plan view corresponding to Fig. 2 of yet another embodiment according to the present invention.

Substrate alignment mechanism 21 attached to rotary shaft 12 via guide base 20 according to the present example includes two pairs of location correcting members 24-2, 24-3, 24-3, 24-3 which are coupled to air cylinder 22, respectively. One pair of location correcting members 24-2, 24-3 are disposed on X-axis with placing substrate 18 between them, the other pair of location correcting members 24-3, 24-3 are disposed on Y-axis with placing substrate 18 between them. Location correcting member 24-2 for X-axis has a substantially T-shaped arm (see Fig. 11(b)), while location correcting members 24-3 have substantially U-shaped arm (see Fig. 11(c)) in order to avoid collision between member 24-3 and carrying arm.

In this embodiment, two pair of location correcting members align the substrate in X-axis direction and Y-axis direction respectively. Although more than two location correcting members are provided, loads of all location correcting members are applied on rotary shaft 12 via guide base 20 and they do not affect carrying arm 14. If there is a fear that location correcting members 24-3 collide with carrying arm 14 when carrying arm 14 extends, assenting and descending mechanism may be additionally provided to move carrying arm 14 vertically. Before carrying arm 14 is extended, carrying arm 14 is moved upwardly to the place where it can avoid collisions with location correcting members 24-3.

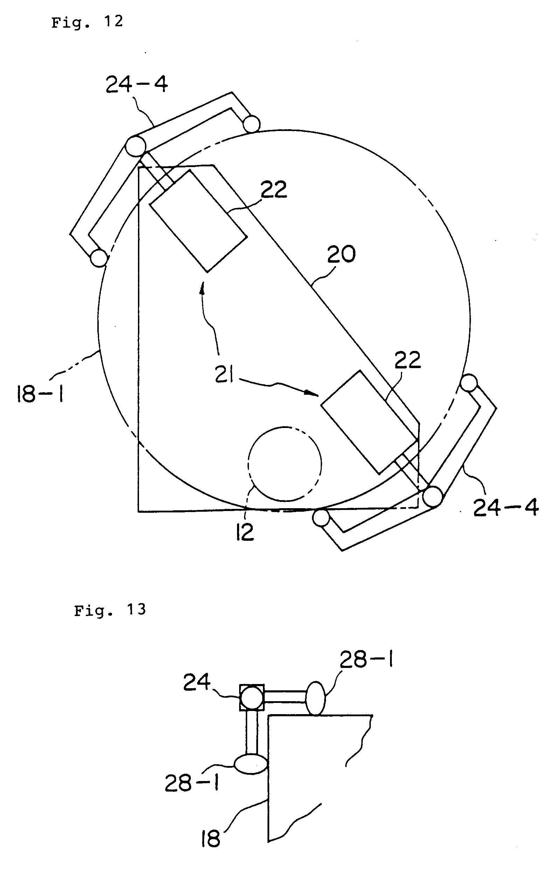

Fig. 12 is a plan view corresponding to Fig. 2 of still another embodiment according to the present invention.

Substrate alignment mechanism 21 attached to rotary shaft 12 via guide base 20 according to the present example includes a pair of location correcting members 24-4, 24-4. This pair of location correcting members 24-4, 24-4 are disposed on one of diameters of circular substrate 18-1 to be placed on substrate receiver 16 with placing substrate 18 between them. Each location correcting members 24-4 has at least two contacting portions which can be brought into contact with substrate 18-1. This example can applies to circular substrate 18 in a similar manner to the case of the rectangular substrate 18. In the case of more than two location correcting members are provided, they are preferably disposed at an equal interval on a circumference direction.

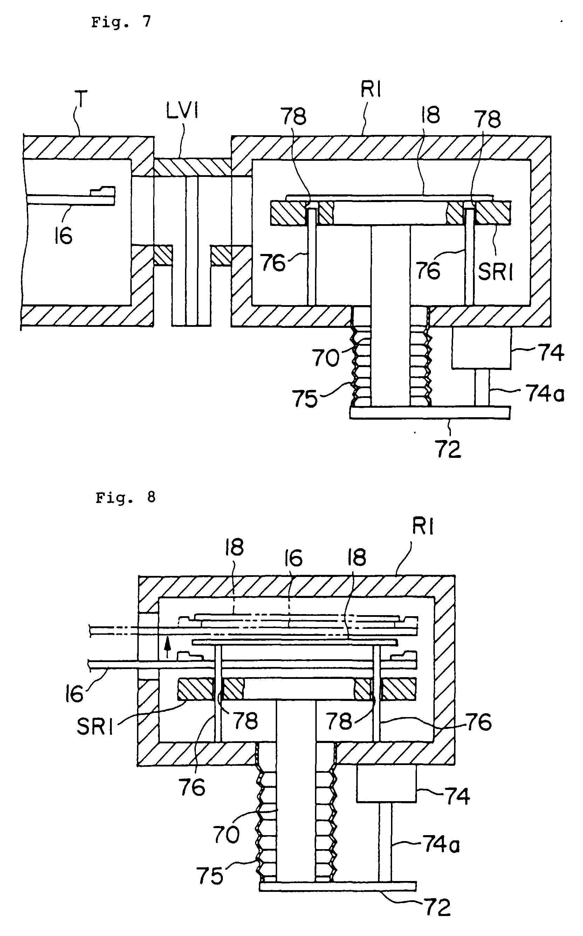

Fig. 6 is a layout drawing of an example of semiconductor manufacturing apparatus in which the substrate carrying apparatus of the present invention is used.

The substrate carrying apparatus of the present invention is applied for carrying processed substrates 18 in a vacuum from processing room R1 to processing room R2 as shown in Fig. 6. "T" designates a transporting room in which the substrate carrying apparatus of the present invention is installed.

Fig. 7 is a sectional view of the processing room R1 of Fig. 1, in which a susceptor SR1 is ascending. Susceptor SR1 on which processed substrates 18 are put is mounted in processing room R1 so as to be able to ascend and descend. Susceptor SR1 is supported by shaft 70, the bottom end of which is connected with connecting plate 72. The connecting plate 72 is in turn connected with one end of movable piston rod 74a of cylinder 74 which is attached securely to processing room R1 so that susceptor SR1 ascends and descends together with vertical movement of connecting plate 72 by motion of cylinder 74. Numeral 75 designates a bellows for securing a vacuum in processing room R1, which connects processing room R1 with connecting plate 72 to be able to extend and contract. Further, inside processing room R1, a plurality of fixing pins 76 are inserted into through holes 78 which are provided in susceptor SR1.

Processing room R2 has the same construction as processing room R1.

Referring to Figs. 7 through 9, the procedure for carrying processed substrate 18 from processing room R1 to processing room R2 is explained. The following consecutive operations are controlled by controller 80 (see Fig. 6).

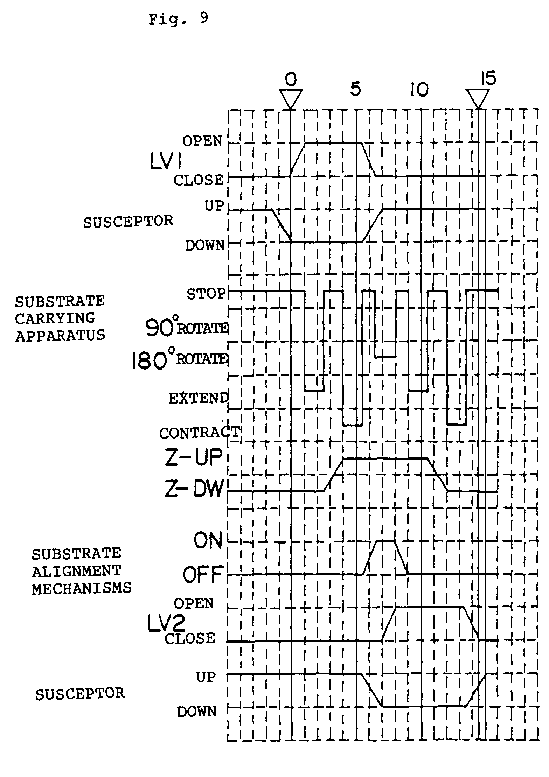

First, piston rod 74a of cylinder 74 is extruded so that connecting plate 72 is moved downward so that susceptor SR1 of processing room R1 descend (t=0 in Fig. 9). Thereby, as shown in Fig. 8, fixing pins 76 are protruded from through holes 78 of susceptor SR1 so that the top ends of fixing pins supports processed substrate 18. In this time, substrate carrying apparatus 10 has been stopped and substrate alignment mechanism 24 is in a state of inactivity. Gate valve LV2 of processing room R2 has been shut and susceptor SR2 in processing room R2 has ascended.

Gate valve LV1 of processing room R1 is then opened, piston rod 22a of air cylinders 22 are extruded so that arm 25 is kept away from substrate 18. In this state, carrying arm 14 is extended, as shown in Fig. 8 so that substrate receiver 16 is moved under substrate 18, through between a plurality of fixing arms 76. Then, carrying arm 14 and substrate receiver 16 is moved upward by driving motor 32 for vertical movement of rotary shaft and carrying arm so that processed substrate 18 is received by substrate receiver 16( this state is shown with imaginary line in Fig. 8). Thereafter, motor 46 for rotation of arm is driven so that carrying arm 14 is contracted. Then, gate valve LV1 of processing room R1 is shut, thereafter susceptor SR1 in processing room R1 ascends, while susceptor SR2 of processing room R2 descends(t=7 in Fig. 9).

Then, piston rods 22a of air cylinder 22 is withdrawn, arm 25 is driven, and alignment of processed substrate 18 is made by contact portion 28. Then, while alignment of processed substrate 18 is preserved, motor 44 for rotating rotary shaft is driven so that rotary shaft 12 is turned 180 degrees, by which substrate 18 is directed toward processing room R2, and then gate valve LV2 of processing room R2 is opened( t=8 in Fig. 9 ). Thereafter, piston rods 22a of air cylinders 22 are extruded, so that arm 25 is kept away from substrate 18. After the holding of processed substrate 18 is released, processed substrate 18 is carried by carrying arm 14 being extended. In processing room R2, the procedure in processing room R1 is reversed, substrate receiver 16 descends, and substrate 18 is supported by fixing pins 76, thereafter carrying arm 14 is contracted. Then, gate valve LV2 of processing room R2 is shut, susceptor SR2 ascends so that substrate 18 is put on susceptor SR2 (t=15 in Fig. 9).

In the above-mentioned rotary action of substrate carrying apparatus 10 during carrying substrate, since processing substrate 18 is held by contact portion 28 of substrate alignment mechanism 24, and even if rotary shaft 12 is rotated at high speed, a shift of substrate from the proper location does not occur, therefore the sure carrying of substrate can be made. Since load of substrate alignment 24 is applied on guide base 20, the load is not applied on carrying arm 14.

Particularly, in case that processing rooms and carrier rooms as shown in Fig. 6 are arranged alternately and processed substrate is carried into one processing room by means of a substrate carrying apparatus in a carrier room, and the processed substrate is carried out of the carrier room by another substrate carrying apparatus, a shift of substrate from the proper location is increased if substrate alignment mechanisms are not used. However, when individual substrate carrying apparatus is provided with substrate alignment mechanism so that a shift of substrate from the proper location made during rotation of substrate carrying apparatus is suppressed, the accuracy in carrying of substrate can be improved so that substrate can be always located at a given place in a processing room.

Further, collision and falling of substrate out of carrying arm which occur inside a processing room, and collision of when substrate is packed into a cassette or other due to increase in a shift of substrate from the proper location can be prevented.

Further, a state of heating of individual substrate and a state of gas flow can be held constant. The accuracy in process of substrate can be improved by improving the uniformity of process between individual substrates.

## Claims

1. A substrate carrying apparatus comprising: a frame; a rotary shaft supported by the frame so as to be rotatable and movable vertically relative to the frame; a carrying arm pivoted to the rotary shaft; a substrate receiver attached to an end of the carrying arm, wherein a substrate is put on the substrate receiver,
wherein the substrate carrying apparatus further comprises substrate alignment mechanism means for locating the substrate on the substrate receiver; said substrate alignment mechanism means being attached to the rotary shaft via a guide base.

2. A substrate carrying apparatus as claimed in claim 1, wherein the substrate alignment mechanism includes at least a pair of location correcting members which are coupled to driving means and disposed so as to oppose with each other with placing the substrate between the pair of location correcting members, and each locating correction member is displaced by the driving means so that it can be brought into contact with the substrate.

3. A substrate carrying apparatus as claimed in claim 1, wherein the substrate alignment mechanism includes at least a pair of location correcting members, one of which is fixed to the guide base and the other of which is coupled to driving means, and said location correcting members are disposed so as to oppose with each other with placing the substrate between them, and the other of the location correcting members is displaced by the driving means so that each locating correction member can be brought into contact with the substrate.

4. A substrate carrying apparatus comprising: a frame; a rotary shaft supported by the frame so as to be rotatable and movable vertically relative to the frame; a carrying arm pivoted to the rotary shaft; a substrate receiver attached to an end of the carrying arm, wherein a substrate is put on the substrate receiver,
wherein the substrate carrying apparatus further comprises a guide base which is fixed to the rotary shaft in such a manner that the guide base is approximately parallel to the substrate receiver below the substrate receiver; driving means supported by the guide base; location correcting members extending above the substrate receiver and coupled to the driving means, wherein the location correcting members are displaced by the driving means so that the substrate is held in place.

5. A substrate carrying apparatus as claimed in any of claims 2 to 4, wherein the location correcting members are disposed on a diagonal line of the rectangular substrate.

6. A substrate carrying apparatus as claimed in claim 5, wherein each location correcting members can be brought into contact with adjacent sides of the substrate at a corresponding corner of the rectangular substrate.

7. A substrate carrying apparatus as claimed in any of claims 2 to 6, wherein each location correcting members has a contact portion which has a circular profile from a plan view.

8. A substrate carrying apparatus as claimed in any of claims 2 to 6, wherein each location correcting members has a contact portion which has an ellipse profile from a plan view.

9. A substrate carrying apparatus as claimed in any of claims 1 to 8, wherein the substrate receiver has a base portion which is attached to the carrying arm, and a plurality of pawl portions which diverges from the base portion and extends toward a head of individual pawl portion, wherein width of individual pawl portion tapers down toward the head.

10. A substrate carrying apparatus as claimed in claim 9, wherein the thickness of individual pawl portion is thinner toward the head.

11. A substrate carrying apparatus as claimed in any of claims 9 to 10, wherein the substrate receiver comprises a bridge portion which connects the pawl portions with each other at appropriate positions of the pawl portions.
